Europäisches Patentamt

European Patent Office

Office européen des brevets

(11) Veröffentlichungsnummer: **0 359 861**
**A1**

## (12) EUROPÄISCHE PATENTANMELDUNG

(21) Anmeldenummer: **88115710.1**

(22) Anmeldetag: **23.09.88**

(51) Int. Cl.⁵: **G01R 1/073**

(43) Veröffentlichungstag der Anmeldung:
**28.03.90 Patentblatt 90/13**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Rittler, Horst**
**Steinacker 4**
**D-7526 Ubstadt-Weiher(DE)**

(54) **Vorrichtung zum elektrischen Prüfen von grossflächigen Verdrahtungsträgern.**

(57) Die Vorrichtung ist mit zwei getrennt verschiebbaren Tastelementeträgern (8) versehen, die sich streifenförmig über die volle Breite des Verdrahtungsfeldes (1) erstrecken und einen entsprechenden Teilbereich (11) des Verdrahtungsträgers (3) erfassen. Die Tastelementeträger (8) sind in Längsrichtung des Verdrahtungsträgers (3) derart verschiebbar, daß sämtliche Teilbereiche (11) miteinander kombiniert werden können.

EP 0 359 861 A1

FIG 3

## Vorrichtung zum elektrischen Prüfen von großflächigen Verdrahtungsträgern

Die Erfindung bezieht sich auf eine Vorrichtung zum elektrischen Prüfen von großflächigen Verdrahtungsträgern, insbesondere von Rückwandverdrahtungen von Baugruppenmagazinen.

Derartige Verdrahtungsträger sind mit einer Vielzahl von rasterartig verteilten Anschlußstiften für elektrische Verbindungen versehen. Diese Anschlußstifte dienen als Prüfpunkte für eine aufzusetzende Prüfvorrichtung.

Bisher war es üblich, universelle Prüfvorrichtungen zu verwenden, die an jedem möglichen Prüfpunkt, d. h. an jedem Rasterpunkt eine gefederte Tastnadel aufweisen, die elektrisch mit einer elektronischen Prüfeinrichtung verbunden ist. Da innerhalb des Verdrahtungsträgers elektrische Verbindungen zwischen beliebigen Anschlußstiften möglich sind, muß die Prüfvorrichtung in der Lage sein, zwischen beliebig ausgewählten Anschlußstiften eine elektrische Prüfschaltung herzustellen.

Aus diesem Grunde war es bisher üblich, eine Abtasteinheit der Prüfvorrichtung den Abmessungen des Verdrahtungsträgers derart anzupassen, daß für jeden möglichen Prüfpunkt des Verdrahtungsträgers eine Tastnadel vorgesehen ist. Bei modernen elektronischen Geräten ist die Rasterteilung von 5 mm auf 2,5 mm verringert worden. Dies führt zu Rückwandverdrahtungen von mehr als 20.000 Rasterpunkten, die eine entsprechende Anzahl von Tastnadeln mit einem entsprechend großem Schaltfeld im elektronischen Teil der Prüfvorrichtung erfordern. Außerdem summieren sich die Federkräfte der einzelnen Tastnadeln zu einer sehr hohen Gesamtkraft, die einen hohen Aufwand hinsichtlich der mechanischen Stabilität der Prüfvorrichtung bedingt.

Der Erfindung liegt die Aufgabe zugrunde, die Prüfvorrichtung mit geringerem Aufwand herstellen zu können.

Diese Aufgabe wird durch die Erfindung gemäß Anspruch 1 gelöst. Da nun nur verhältnismäßig kleine Teilbereiche des Verdrahtungsträgers adaptiert werden müssen, verringert sich die Anzahl der Tastelemente mit den zugehörigen elektrischen Verbindungen. Dementsprechend kleiner fallen die elektrischen Schaltfelder mit den zugehörigen elektronischen Schalteinrichtungen aus. Im Verhältnis zu der gesamten Prüfzeit ist der zeitliche Mehraufwand zum Verschieben der Tastelementeträger vernachlässigbar klein. Es versteht sich, daß dabei die Tastelementeträger nach Möglichkeit zum jeweils nächstliegenden Teilbereich verfahren werden.

Vorteilhafte Weiterbildungen der Erfindung sind in den Ansprüchen 2 bis 4 gekennzeichnet:

Durch die Weiterbildung nach Anspruch 2 brauchen die Tastelementeträger lediglich in einer Koordinatenrichtung verschoben zu werden, so daß der mechanische Aufwand für das Verschieben begrenzt ist. Außerdem brauchen die Koordinatenwerte der Tastelemente in einer der Koordinatenrichtungen in den verschiedenen Tastpositionen nicht verändert zu werden, wodurch der elektronische Steuerungsaufwand klein gehalten werden kann.

Die Weiterbildung nach Anspruch 3 ermöglicht es, die Prüfpunkte ohne Zwischenschritte lückenlos abzutasten. Die Nadelträger sind so konstruiert, daß die Tastelemente auf den einander zugewandten Seiten bis unmittelbar an den Rand des Nadelträgers heranreichen.

Durch die Weiterbildung nach Anspruch 4 wird die Aufsetzbewegung durch den Hubtisch ausgeführt. Diese Funktion wäre bei den bewegbaren Nadelträgern nur mit erheblichen Mehraufwand zu realisieren.

Im folgenden wird die Erfindung anhand eines in der Zeichnung dargestellten Ausführungsbeispieles näher erläutert.

Fig. 1 ist eine schematisierte Seitenansicht eines Teils eines Verdrahtungsträgers und einer Prüfvorrichtung mit einem Hubtisch und zwei Tastelementeträgern,

Fig. 2 eine schematisierte Draufsicht auf den Verdrahtungsträger und die Tastelementeträger nach Figur 1,

Fig. 3 eine schematisierte Seitenansicht der Prüfvorrichtung nach Figur 1.

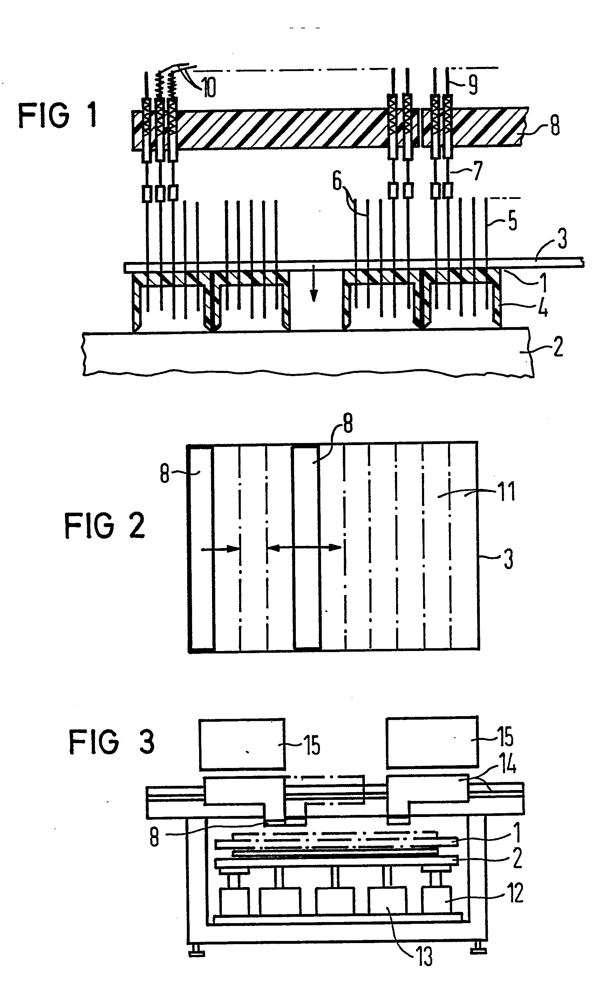

Nach Figur 1 liegt ein als Rückwandverdrahtung eines Baugruppenmagazins ausgebildeter Verdrahtungsträger 1 auf einem Hubtisch 2 einer Prüfvorrichtung auf. Der Verdrahtungsträger 1 besteht aus einer Leiterplatte 3 und Rückwandsteckern 4 mit Steckerstiften 5, die durch die Leiterplatte 3 hindurchragen. Die Steckerstifte 5 sind über die gesamte Verdrahtungsebene des Verdrahtungsträgers 1 in einem engmaschigen Raster verteilt angeordnet. Ihre dem Hubtisch 2 abgewandten freien Enden dienen als Prüfpunkte 6 für federnde Tastelemente 7 zweier Tastelementeträger 8, die über den Steckerstiften angeordnet sind. Der Hubtisch 2 drückt die Steckerstifte 5 gegen die nadelartigen Tastelemente 7, die in dem plattenartigen Tastelementeträger 8 verankert sind. Diese weisen auf der den Steckerstiften abgewandten Seite Anschlußstifte 9 auf, an die Schaltdrähte 10 angeschlossen sind, die mit zwei elektronisch gesteuerten Schaltfeldern elektrisch verbunden sind.

Die Prüfpunkte 6 sind durch den Hubtisch 2 gegen die freien Enden der Tastelemente 7 gedrückt, so daß eine sichere Kontaktierung zustande kommt. Der Hubtisch 2 kann in der angedeuteten Pfeilrichtung soweit abgesenkt werden, daß die Tastelementeträger 8 über dem Verdrahtungsträger 1 parallel zu dessen Er streckungsebene verschoben werden können. Auf den einander zugewandten Seiten der Verdrahtungsträger 8 sind die Tastelemente 7 so nah am Rand angeordnet, daß die Steckerstifte 5 lückenlos kontaktiert werden können.

Nach Figur 2 überdecken die Tastelementeträger 8 streifenförmig die gesamte Breite des Verdrahtungsträgers 3. Dieser ist gemäß den strichpunktierten Linien in aneinander gereihte streifenförmige Teilbereiche 11 unterteilt, deren Abmessungen den Tastelementeträgern 8 entsprechen. Diese sind gemäß den dargestellten Pfeilen in der Längsrichtung des Verdrahtungsträgers 3 derart verschiebbar, daß sämtliche Teilbereiche 11 paarweise miteinander kombiniert werden können, so daß beliebige Kombinationen von Steckerstiften des Verdrahtungsträgers 3 z. B. auf Durchgang und Isolation geprüft werden können.

Figur 3 zeigt den mechanischen Aufbau der Prüfvorrichtung ohne den elektronischen Steuerungteil. Der Hubtisch 2 ist an Säulenführungen 12 geführt und an Andruckelementen 13 abgestützt. Diese ermöglichen das Anheben und Absenken des Hubtisches 2. Über den aufgelegten Verdrahtungsträger 1 sind die Tastelementeträger 8 mittels einer Schlittenführung 14 verschiebbar geführt. Den Tastelementeträgern 8 sind zwei Schaltfelder 15 zugeordnet, die mit einer nicht dargestellten elektronischen Prüfeinrichtung und Steuerung elektrisch verbunden sind.

Bezugszeichenliste

  1 Verdrahtungsträger
  2 Hubtisch
  3 Leiterplatte
  4 Rückwandstecker
  5 Steckerstift
  6 Prüfpunkt
  7 Tastelement
  8 Tastelementeträger
  9 Anschlußstift
  10 Schaltdraht
  11 Teilbereich
  12 Säulenführung
  13 Andruckelement
  14 Schlittenführung
  15 Schaltfeld

**Ansprüche**

1. Vorrichtung zum elektrischen Prüfen von großflächigen Verdrahtungsträgern (1) insbesondere von Rückwandverdrahtungen von Baugruppenmagazinen, wobei der Verdrahtungsträger (1) ein Feld von in einem engmaschigen Raster verteilten Prüfpunkten (6) aufweist, die sämtlich mit Tastelementen (7) der Vorrichtung kontaktierbar sind, **dadurch gekennzeichnet,** daß die Vorrichtung zumindest zwei getrennte Tastelementeträger (8) aufweist, die je einen Teilbereich (11) des Prüfpunktfeldes überdecken, daß darüber die Tastelementeträger (8) getrennt verschiebbar sind, daß die Tastelementeträger (8) über zumindest eine Schalteinrichtung (z. B. 15) elektrisch miteinander verbindbar sind daß die beiden Tastelementeträger (8) jeden Teilbereich (11) in Kombination mit jedem anderen Teilbereich (11) des Prüfpunktfeldes kontaktieren können.

2. Vorrichtung nach Anspruch 1, **dadurch gekennzeichnet,** daß sich die Tastelementeträger (8) streifenförmig über die volle Breite des Prüfpunktfeldes des Verdrahtungsträgers (1) erstrecken und in Längsrichtung des Verdrahtungsträgers (1) verschiebbar sind.

3. Vorrichtung nach Anspruch 2, **dadurch gekennzeichnet,** daß die Tastelementeträger (8) in einer Schlittenführung (14) verschiebbar sind und daß bei der Kontaktierung unmittelbar benachbarter Teilbereiche (11) die zugehörigen Prüfpunkte (6) lückenlos kontaktierbar sind.

4. Vorrichtung nach Anspruch 2 oder 3, **dadurch gekennzeichnet,** daß der Verdrahtungsträger (1) auf einem Hubtisch (2) aufliegt, daß die Tastelemente (7) als federnde Stifte ausgebildet sind und daß der Verdrahtungsträger (1) gegen die Tastelemente (7) drückbar ist.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | US-A-4 471 298 (FROHLICH) <br> * Spalte 5, Zeilen 41-62; Spalte 6, Zeilen 3-15; Spalte 8, Zeilen 38-48; Spalte 8, Zeile 58 - Spalte 9, Zeile 17; Zusammenfassung; Figuren 1-5 * <br> --- | 1-4 | G 01 R 1/073 |
| X | EP-A-0 105 010 (GERTY S.A.R.L.) <br> * Seite 2, Zeile 24 - Seite 3, Zeile 8; Seite 4, Zeilen 22-32; Seite 6, Zeile 18 - Seite 7, Zeile 8; Zusammenfassung; Figuren 1,2 * | 1-3 | |
| A | --- | 4 | |
| X | DE-A-2 013 070 (LICENTIA) <br> * Seite 2, Zeilen 16-39; Seite 4, Zeilen 19-23; Seite 6, Zeilen 12-16; Figuren 1,2 * <br> --- | 1-3 | |
| X | DE-A-2 800 775 (LUTHER & MAELZER) <br> * Seite 10, Zeile 11 - Seite 11, Zeile 9; Figuren 4,8,10 * | 1-3 | |
| A | ----- | 4 | **RECHERCHIERTE SACHGEBIETE (Int. Cl.3)** <br><br> G 01 R |

Der vorliegende Recherchenbericht wurde für alle Patentansprüche erstellt

| Recherchenort | Abschlußdatum der Recherche | Prüfer |
|---|---|---|
| DEN HAAG | 25-05-1989 | WIEMANN L. |